# EUROPEAN PATENT SPECIFICATION

(11) **EP 4 213 203 B1**
(45) Date of publication and mention of the grant of the patent: **04.03.2026**
(21) Application number: 22151115.7
(22) Date of filing: 12.01.2022
(51) Int. Cl.: H01L 23/495

(54) **SEMICONDUCTOR DEVICE PACKAGE AND METHOD FOR MANUFACTURING THE SAME**
GEHÄUSE FÜR EIN HALBLEITERBAUELEMENT UND VERFAHREN ZUR HERSTELLUNG DAVON
BOÎTIER DE DISPOSITIF SEMICONDUCTEUR ET SON PROCÉDÉ DE FABRICATION

(43) Date of publication of application: 19.07.2023
(73) Proprietor: Nexperia B.V., 6534 AB Nijmegen (NL)
(72) Inventor: Yandoc, Ricardo, 22529 Hamburg (DE); Brown, Adam, 22529 Hamburg (DE); Zhou, Zhou, Kwaichung (HK)
(74) Representative: Pjanovic, Ilija

(56) References cited:
- WO-A1-2020/208867
- JP-A- 2000 349 207
- JP-A- H05 343 578
- US-A1- 2009 096 100
- US-A1- 2011 241 198
- US-A1- 2015 145 111
- US-A1- 2022 148 946

## Description

Aspects of the present disclosure relate to a semiconductor device package and a method for manufacturing the same. The present disclosure relates particularly to leadframe-based semiconductor device packages.

Semiconductor device packages typically comprise a one or more semiconductor dies on which one or more electronic components are integrated. The semiconductor die(s) is or are generally encapsulated by a package material to protect said semiconductor die(s) from external damages, such as physical or thermal stress. In a leadframe-based package, connections in the form of (clip) leads may be provided that extend from within the package material to an outside of the package to be able to contact one or more terminals of the electronic component(s).

Examples of semiconductor device packages known in the art are shown in WO2020/208867A1, US2009/096100A1, JPH05343578A, JP2000349207A, US2011/241198A1 and US2015/145111A1.

Semiconductor device packages, in particular the semiconductor die(s) thereof, may be susceptible to thermomechanical stress. If the package is placed under stress for an extended period of time, significant and sometimes even permanent damage to the package may ensue, possibly resulting in failure of the semiconductor die(s) or the electronic component(s) integrated thereon.

It is an object of the present disclosure to provide a semiconductor device package for which the abovementioned problem(s) do not occur or hardly so.

According to an aspect of the present disclosure, a semiconductor device package is provided, comprising a semiconductor die having an electronic component integrated thereon and having a die terminal that is electrically connected to the electronic component, a stress relief substrate fixedly and electrically connected to the die terminal, and a clip lead. The substrate is configured to provide an electrical short between the die terminal and the clip lead.

The Applicant has found that the clip lead is typically a source of thermomechanical stress on the semiconductor die, both during manufacturing (e.g., while providing the clip) and after (e.g., during operational use of the package). The stress relief substrate may form an interface between the clip lead and the semiconductor die and may thereby reduce stress exerted on the semiconductor die by said clip lead.

In accordance with the present disclosure, the substrate is configured to bridge a difference between a coefficient of thermal expansion of the clip lead and a coefficient of thermal expansion of a die substrate of the semiconductor die. Furthermore, the substrate has a coefficient of thermal expansion that is lower than that of the clip lead. The die substrate may for example comprise a semiconductor material such as silicon, or sapphire, which typically have a lower coefficient of thermal expansion than the clip lead, which may be a metal such as copper.

Materials may expand or contract due to a change in temperature. In particular, different materials may expand at different rates and by different amounts. For example, the material forming the clip lead may typically expand more than the material forming the die substrate of the semiconductor die. Due to this differential in coefficient of thermal expansion, if the clip lead is fixedly attached to the die terminal, the clip lead may exert a thermomechanical force on the semiconductor die due to a greater expansion of the clip lead. This thermomechanical force may damage parts of the semiconductor die or may damage layers arranged on top of the semiconductor die. For example, typically, cracking may occur in a passivation layer or intermetallic dielectric layer on top of the semiconductor die under thermomechanical stress due to the force exerted by the clip lead.

In the semiconductor device package according to the present disclosure, a stress relief substrate is provided that bridges a difference in thermal expansion coefficient between the clip lead and the semiconductor die. For example, the coefficient of thermal expansion of the substrate may be closer to that of the semiconductor die with respect to the clip lead. As such, the semiconductor die may experience less thermomechanical stress.

The substrate may be configured to distribute a mechanical force exerted by clip lead. In some embodiments, a contact surface area of the substrate with respect to the die terminal may be greater than a contact surface area of the clip lead with respect to the substrate.

The substrate may comprise a dielectric material having arranged therein a plurality of conductive vias. The clip lead may be electrically connected to the die terminal through said plurality of conductive vias. In some embodiments, the substrate may comprise a printed circuit board, 'PCB', including said dielectric material and conductive vias. The conductive vias may for example comprise a conductive material, such as copper, gold, aluminum, tungsten, nickel or graphene. The dielectric material may have a coefficient of thermal expansion that is closer to that of the semiconductor die with respect to the clip lead, and may thus be highly suitable to form the stress relief substrate. The conductive vias may provide the electrical short between the clip lead and the die terminal for electrically connecting said clip lead and said die terminal.

Alternatively, the substrate may comprise a crystalline or polycrystalline silicon material, and the clip lead may be electrically connected to the die terminal through said crystalline or polycrystalline material. Crystalline and polycrystalline silicon may have a thermal expansion coefficient that is closer to that of the semiconductor die with respect to the clip lead, and may be highly suitable to form the stress relief substrate.

The clip lead may comprise a first end that is fixedly and electrically connected to the substrate. A contact surface area of the substrate with respect to the die terminal may be greater than a contact surface area of the clip lead with respect to the substrate.

The semiconductor device package may further comprise a package material that encapsulates the semiconductor die and the substrate. The clip lead may comprise a second end that is arranged externally to the package material. The package material may comprise a molding compound.

The die terminal may be arranged in a metal layer of a layer stack on top of the semiconductor die, the layer stack comprising a stack of one or more metal layers, one or more intermetallic dielectric layers and one or more passivation layers.

The semiconductor die may be arranged on a die pad. In some embodiments, the die pad may be conductive and may be electrically connected to the electronic component.

The semiconductor device package may further comprise a further semiconductor die having a further electronic component integrated thereon and having a first further die terminal that is electrically connected to the further electronic component. The first further die terminal may be fixedly and electrically connected to another die terminal of the semiconductor die. Furthermore, the semiconductor device package may further comprise a further clip lead, a first end thereof being fixedly and electrically connected to a second further die terminal of the further semiconductor die that is electrically connected to the further electronic component, and a second end thereof being arranged externally to the package material.

In some embodiments, a thickness of the further semiconductor die may correspond to a thickness of the substrate. This enables forming the clip lead and the further clip lead in a similar manner, even though the further clip lead may not have a substrate associated therewith. For example, the further semiconductor die and the substrate may have a thickness in a range between 100-200 micron, such as about 150 micron, though the present disclosure is not limited thereto.

The electronic component and/or, if applicable, the further electronic component may comprise a bipolar junction transistor (BJT) or a field-effect transistor (FET), such as a high electron mobility transistor (HEMT) or a power metal oxide semiconductor FET, MOSFET. In some embodiments, the electronic component and the further electronic component may together form a cascode circuit or a half-bridge circuit. In other words, the semiconductor die and the further semiconductor die may be arranged such that the terminals of the FET and of the HEMT are electrically connected in a manner to form a cascode or half-bridge circuit. In this manner, a cascode or half-bridge circuit can be conveniently packaged together in a single semiconductor device package that can additionally mitigate thermomechanical stress exerted by the clip lead.

The clip lead may be fixedly and electrically connected to the substrate using a conductive adhesive material. Additionally or alternatively, the substrate is fixedly and electrically connected to the die terminal using a conductive adhesive material. Additionally or alternatively, if applicable, the semiconductor die may be fixedly and electrically connected to the die pad using a conductive adhesive material. Additionally or alternatively, the further clip lead may be fixedly and electrically connected to the second further die terminal using a conductive adhesive material. Additionally or alternatively, the further semiconductor die may be fixedly and electrically connected to the another die terminal of the semiconductor die using a conductive adhesive material. **In** each of these embodiments, the conductive adhesive material may comprise a conductive epoxy, a solder layer, such as tin, or a sinter layer, such as sintered silver or copper, though the present disclosure is not related to a particular conductive adhesive material.

The clip lead and, if applicable, the further clip lead may be gullwing-shaped. Additionally or alternatively, the semiconductor die and/or, if applicable, the further semiconductor die may be based on one of Silicon, 'Si', Gallium Nitride, 'GaN', Silicon Carbide, 'SiC', or Gallium Arsenide, 'GaAs', technology.

According to another aspect of the present disclosure, a method for manufacturing a semiconductor device package is provided, comprising the steps of a) providing a semiconductor die having an electronic component integrated thereon and having a die terminal that is electrically connected to the electronic component, b) providing a stress relief substrate as described above, and fixedly and electrically connecting said substrate to the die terminal, and c) providing a clip lead, wherein the substrate provides an electrical short between the clip lead and the die terminal.

The clip lead may comprise a first end that is fixedly and electrically connected to the substrate. **In** some embodiments, a contact surface area of the substrate with respect to the die terminal may be greater than a contact surface area of the clip lead with respect to the substrate.

Additionally or alternatively, the method may further comprise the step of d) providing a package material, and arranging said package material to encapsulate the semiconductor die and the substrate, a second end of the clip lead being arranged externally to the package material. For example, the package material may be a molding compound, and step d may comprise applying said molding compound and allowing said molding compound to solidify to thereby form a body of solidified molding compound that encapsulates at least the substrate and the semiconductor die.

The semiconductor die may be fixedly arranged on a die pad, and the die pad may be comprised in a leadframe. **In** some embodiments, the die pad may be conductive and may be electrically connected to the electronic component. The leadframe may further comprise a frame portion to which the die pad is fixedly connected. The method may further comprise a step of e) singulating the semiconductor device package from the leadframe, for example by performing at least one of punching, drilling, cutting or sawing. **In** some embodiments, the leadframe may comprise a plurality of said frame portions and die pads for manufacturing a plurality of said semiconductor device packages.

Step b) may further comprise providing a further semiconductor die having a further electronic component integrated thereon and having a first further die terminal that is electrically connected to the further electronic component. The first further die terminal may be fixedly and electrically connected to another die terminal of the semiconductor die. Furthermore, step c) may further comprise providing a further clip lead, and fixedly and electrically connecting a first end thereof to a second further die terminal of the further semiconductor die that is electrically connected to the further electronic component. A second end thereof may be arranged externally to the package material. In some embodiments, a thickness of the further semiconductor die may correspond to a thickness of the substrate. The electronic component and/or, if applicable, the further electronic component may comprise a BJT or a FET, such as a HEMT or a power MOSFET. In some embodiments, the electronic component and the further electronic component may together form a cascode circuit or a half-bridge circuit.

The clip lead and, if applicable, the further clip lead may be comprised in one or more clips, wherein the one or more clips comprise a supporting portion that is arranged to be supported by or fixedly connected to the frame portion. Furthermore, the method may further comprise, after step d), separating the clip lead and, if applicable, the further clip lead from the supporting portion, for example by performing at least one of punching, drilling, cutting or sawing.

Fixedly and electrically connecting the clip lead to the substrate may be performed using a conductive adhesive material. Additionally or alternatively, fixedly and electrically connecting the substrate to the die terminal may be performed using a conductive adhesive material. Additionally or alternatively, fixedly and electrically connecting the semiconductor die to the die pad may be performed using a conductive adhesive material. Additionally or alternatively, fixedly and electrically connecting the further clip lead to the second further die terminal may be performed using a conductive adhesive material. Additionally or alternatively, fixedly and electrically connecting the further semiconductor die to the another die terminal of the semiconductor die may be performed using a conductive adhesive material. In some embodiments, the conductive adhesive material may comprise one of a conductive epoxy, a solder layer, such as tin, or a sinter layer, such as sintered silver or copper.

The clip lead and, if applicable, the further clip lead may be formed to be gullwing-shaped, for example by bending the second end of the clip lead and, if applicable, the further clip lead.

The semiconductor die and/or, if applicable, the further semiconductor die may be based on one of Silicon, 'Si', Silicon Carbide, 'SiC', Gallium Nitride, 'GaN', or Gallium Arsenide, 'GaAs', technology.

Next, the present disclosure will be described in more detail with reference to the appended figures, wherein:
Figure 1A is a cross-sectional view of a semiconductor device package according to an embodiment of the present disclosure;
Figure 1B is a top view of a semiconductor device package according to an embodiment of the present disclosure;
Figure 2 is a cross-sectional view of a portion of the semiconductor device package shown in Figures 1A and 1B;
Figure 3 is a top view of a substrate according to an embodiment of the present disclosure; and
Figures 4A-4H illustrate a manufacturing process for manufacturing a semiconductor device package according to an embodiment of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

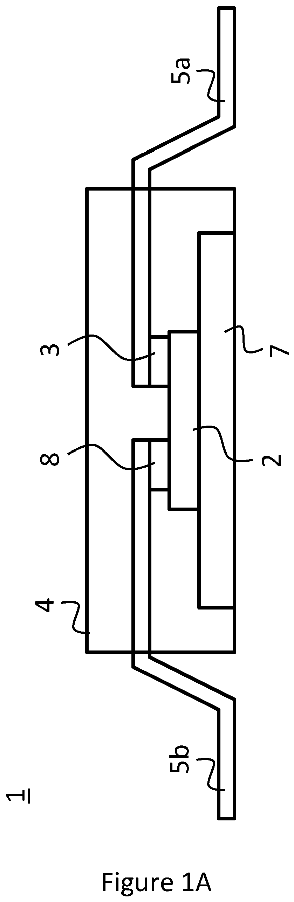

**In** Figure 1A, a cross-sectional side view of a semiconductor device package 1 is shown according to an embodiment of the present disclosure.

Semiconductor device package 1 comprises a semiconductor die 2 that has an electronic component integrated thereon. Semiconductor die 2 is encapsulated by a package material 4 configured to protect semiconductor die 2 from external damages, such as mechanical stress. More in particular, semiconductor die 2 may be arranged on a die pad 7 and may support semiconductor die 2 and form a portion of a bottom surface of semiconductor device package 1.

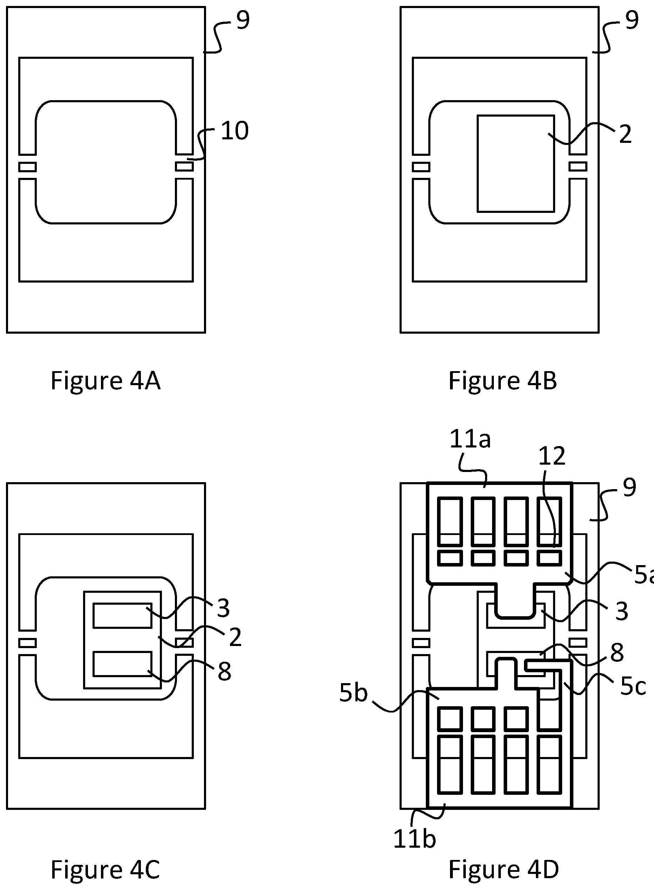

**In** some embodiments, die pad 7 may be omitted. For example, semiconductor die 2 could be arranged on a temporary carrier instead, which may be removed during the manufacturing process, which will be described in greater detail below with reference to Figures 4A-4H.

Typically, the electronic component may have one or more terminals that are accessible from an outside of semiconductor device package 1 through leads, such as a clip lead 5a and a further clip lead 5b. In particular, clip lead 5a and further clip lead 5b shown in Figure 1A are gullwing-shaped leads, and a first end of each lead being arranged inside package material 4 and being fixedly and electrically connected to a component inside package material 4. On the other hand, a second end of clip lead 5a and further clip lead 5b is arranged externally to package material 4. For example, clip lead 5a and further clip lead 5b may be electrically connected to an external circuit via the second end(s). Furthermore, die pad 7 may be conductive, and may be arranged having an exposed bottom surface, as shown in Figure 1A. Then, die pad 7 could be electrically connected to another terminal of the electronic component, and the bottom surface of die pad 7 may enable external access to said another terminal of the electronic component on semiconductor die 2.

In an example, semiconductor die 2 may be based on Gallium Nitride (GaN) technology, and the electronic component may be a high electron mobility transistor (HEMT).

Semiconductor device package 1 further comprises a substrate 3 fixedly and electrically connected to a die terminal (not shown), and clip lead 5a is fixedly and electrically connected to said substrate 3. Clip lead 5a is then electrically connected to the die terminal through at least a portion of substrate 3. The die terminal may be electrically connected to a terminal of the electronic component. For example, the die terminal is arranged in a metal layer on top of semiconductor die 2, and is electrically connected to a terminal of the electronic component using a metal interconnection, such as one or more vias.

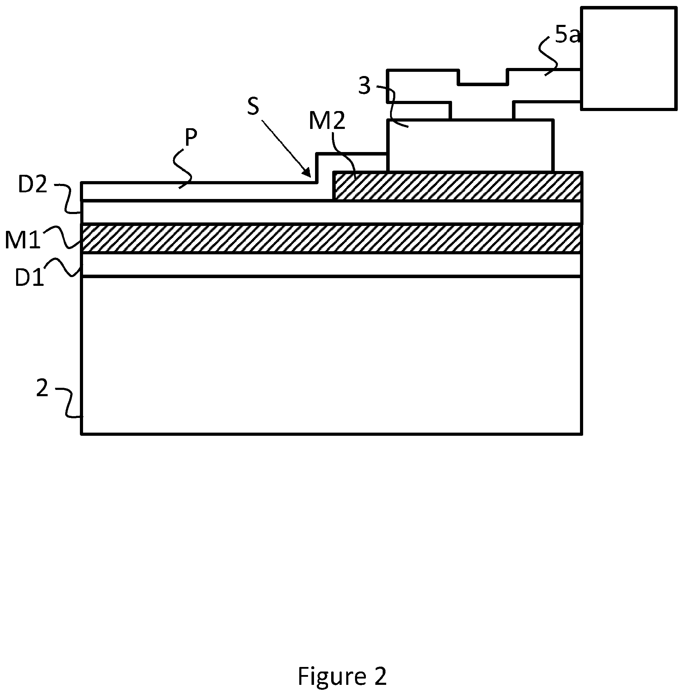

In some embodiments, semiconductor die 2 may comprise a layer stack (not shown in Figure 1A) comprising one or more metal layers, one or more intermetallic dielectric layers, and one or more passive layers. The layer stack will be described in greater detail below with reference to Figure 2.

Clip lead 5a is conductive and typically comprises a metal, such as copper. As a result, a coefficient of thermal expansion thereof may be relatively large with respect to that of semiconductor die 2, in particular a substrate thereof. Due to this difference in coefficient of thermal expansion, a thermomechanical force may be exerted by clip lead 5a on semiconductor die 2 due to a change in temperature, causing potential damages to semiconductor die 2 and possibly even failure of the electronic component integrated thereon. By using substrate 3, stress exerted by an expansion or contraction of clip lead 5a due to a change in temperature is distributed, and a stress exerted on semiconductor die 2 is mitigated. By distributing said force and reducing the stress exerted on semiconductor die 2, a more robust package can be obtained.

A contact surface area of clip lead 5a, by which clip lead 5a is fixedly connected, may be smaller than a contact surface area of substrate 3 by which substrate 3 is fixedly connected to the die terminal.

In some embodiments, semiconductor device package 1 further comprises a further semiconductor die 8. Further semiconductor die 8 may have a further electronic component integrated thereon. For example, the further electronic component may be a field-effect transistor (FET). Further semiconductor die 8 may be fixedly and electrically connected to a die terminal of semiconductor die 2. As such, a terminal of the further electronic component may be electrically connected to a terminal of the electronic component, internally to semiconductor device package 1. Further clip lead 5b may be fixedly and electrically connected to further semiconductor die 8 and may provide external access to another terminal of further electronic component.

The combined circuit formed by the electronic component and the further electronic component may be a cascoded transistor circuit, or a half-bridge circuit. However, the present disclosure also envisages other types of combined circuits to be packaged in semiconductor device package 1. Furthermore, the electronic component and the further electronic component are described as being transistors, the present disclosure is not limited thereto. As an example only, the electronic component or circuit integrated on semiconductor die 2 and/or further semiconductor die 8 may instead be a diode, silicon-controlled rectifier, or the like, or may be combinations of various types of electronic components.

Alternatively or additionally to the above, although only one substrate 3 is shown, one or more other die terminals of semiconductor die 2 may have a respective substrate associated therewith for relieving thermomechanical stress. For example, in absence of further semiconductor die 8, further clip lead 5b may instead be fixedly and electrically connected to another die terminal of semiconductor die 2.

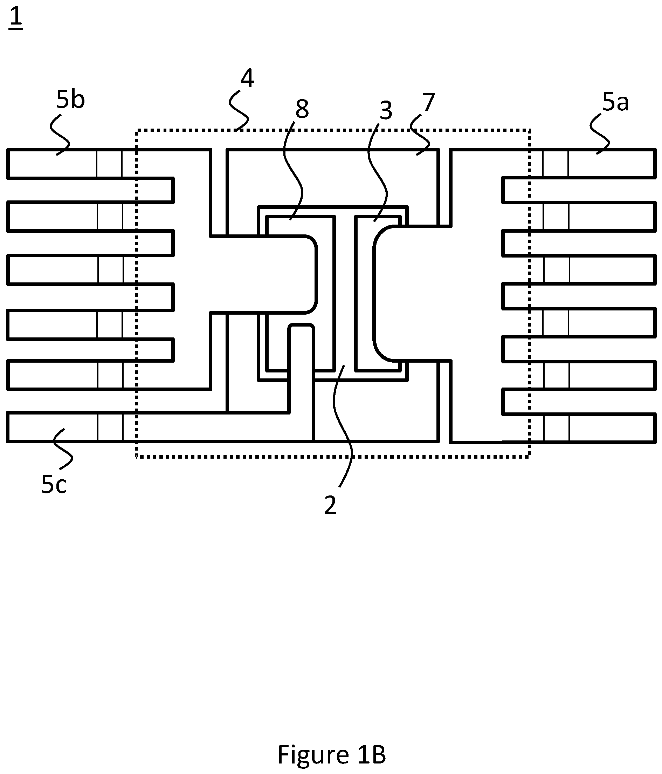

In Figure 1B, an exemplary top view is shown corresponding to semiconductor device package 1 as shown in Figure 1A.

As shown in Figure 1B, clip lead 5a and further clip lead 5b may comprise a plurality of second ends arranged externally to package material 8. The first end of clip lead 5a is fixedly and electrically connected to a top surface of substrate 3, and the first end of further clip lead 5b is fixedly and electrically connected to a top surface of further semiconductor die 8, for example to a die terminal thereof.

In some embodiments, the electronic component integrated on semiconductor die 2 is a first transistor (e.g., a FET), and the further electronic component integrated on further semiconductor die 8 is a second transistor (e.g., a HEMT). For example, further clip lead 5b may correspond to a source terminal of the first transistor, and the drain terminal of the first transistor may be arranged at a bottom surface of further semiconductor die 8 and may be electrically connected to a source terminal of the second transistor. Clip lead 5a may correspond to a drain terminal of the second transistor, and die pad 7 may correspond to a gate terminal of the second transistor. Semiconductor die package 1 may further comprise another further clip lead 5c fixedly and electrically connected to another die terminal of further semiconductor die 8, and may correspond to a gate terminal of the second transistor.

In Figure 2, a cross-sectional view of semiconductor die 2 is shown having a layer stack arranged on top, according to an embodiment of the present disclosure. In particular, the layer stack comprises a plurality of metal layers M1, M2, a plurality of intermetallic dielectric layers D1, D2, and a passivation layer P. Although not shown, portions of metal layers M1, M2 may be interconnected using vias. Here, it is noted that the term 'metal layer' may refer to a plurality of separate portions, for example arranged on a same passivation layer or intermetallic dielectric layer.

In the example shown in Figure 2, the die terminal corresponds to a portion of metal layer M2. Substrate 3 is fixedly and electrically connected to said portion of metal layer M2, and clip lead 5a is in turn fixedly and electrically connected to substrate 3. As shown in Figure 2, the contact surface area of substrate 3 may be greater than the contact surface area of clip lead 5a.

The Applicant has found that, in absence of substrate 3, the package may fail due to short circuits between metal layers of the layer stack. For example, in a high temperature reverse bias (HTRB) test, the Applicant found that stress-related concerns are observed under clip lead 5a in absence of substrate 3. The stress-related concerns correspond to thermomechanical stress leading to micro-cracks in the layers of the layer stack. Typically, such cracks can start in passivation layer P at a position S indicated in Figure 2, and may propagate into intermetallic dielectric layer D2. For example, in absence of substrate 3, cracking may occur at position S due to a force exerted by clip lead 5a on semiconductor die 2 and/or the layers on top of semiconductor die 2 including passivation layer P. Due to the cracking, at a reverse bias, a leakage path can be observed between metal layers M2 and M1. The cracking may at least partially occur due to a difference in thermal expansion of clip lead 5a and the die substrate of semiconductor die 2. In particular, the layer stack on top of semiconductor die 2 may be relatively small with respect to the die substrate of semiconductor die 2. As a result, thermal expansion of semiconductor die 2 is typically dominated by the die substrate of semiconductor die 2.

As described above, by including substrate 3, the stress on semiconductor die 2, such as on the layers of the layer stack, can be reduced significantly. For example, substrate 3 may bridge a difference in coefficient of thermal expansion between clip lead 5a and semiconductor die 2 (or, more particularly, its substrate), and/or may distribute a force exerted by clip lead 5a.

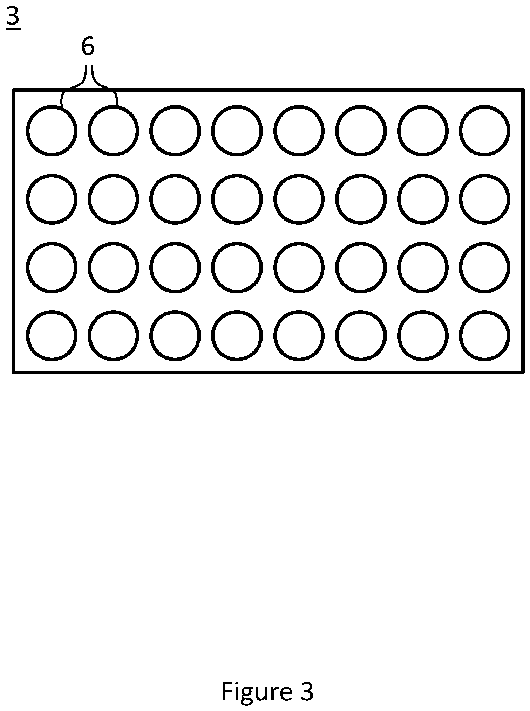

In Figure 3, a top view of substrate 3 according to an embodiment of the present disclosure is shown. In some embodiments, substrate 3 comprises a dielectric layer, such as a PCB, in which a plurality of conductive vias 6 are arranged. Conductive vias 6 may for example be copper or copper-plated vias. A coefficient of thermal expansion of the dielectric layer (e.g., the PCB) may be closer to a coefficient of thermal expansion of semiconductor die 2 (e.g., passivation layers P1-P3 and/or intermetallic dielectric layers D1-D2) compared to clip lead 5a. In some embodiments, the conductive vias 6 are mutually electrically connected via a metal layer (not shown) arranged on one or both of a top side and a bottom side of substrate 3, and conductive vias 6 may extend between said top side and said bottom side.

Conductive vias 6 may occupy a particular amount of a volume of substrate 3. In an example, conductive vias 6 may together form 10-90% of the volume of substrate 3. For example, 50% of the volume of substrate 3 is comprised of conductive vias 6. However, the present invention is not limited to any such amount, and the preferred or optimal amount may depend on the application.

Alternatively to the configuration shown in Figure 3, substrate 3 may comprise a crystalline or polycrystalline silicon material. Polysilicon material may have a coefficient of thermal expansion that is closer to a coefficient of thermal expansion of semiconductor die 2, and may additionally be conductive to provide an electrical short between clip lead 5a and the corresponding die terminal.

Next, a process for manufacturing semiconductor device package 1 according to some embodiments of the present disclosure is described with reference to Figures 4A-4H.

In Figure 4A, a leadframe is provided comprising a frame portion 9 and die pad 7. In particular, die pad 7 may be fixedly attached to frame 9 via tie bars 10. The leadframe may comprise a plurality of said frame portions 9 and a plurality of said die pads 7 for manufacturing a plurality of semiconductor device packages substantially simultaneously. For example, a plurality of frame portions 9 and corresponding die pads 7 may be arranged in a row or in an array during manufacturing. In the ensuing description below, each step may be performed for multiple or each of said frame portions 9 and die pads 7.

Next, in Figure 4B, semiconductor die 2 is fixedly connected to die pad 7, for example using a conductive adhesive material. As an example only, the conductive adhesive material may comprise a solder layer, such as tin, or a sinter layer, such as sintered silver or sintered copper. As described above, if die pad 7 is conductive, then die pad 7 may additionally be electrically connected to a terminal of the electronic component integrated on semiconductor die 2 via said conductive adhesive material.

In Figure 4C, substrate 3 is fixedly and electrically connected to a die terminal of semiconductor die 2. Optionally, a substrate is provided for a plurality of terminals at a top surface of semiconductor die 2. Furthermore, for manufacturing a package comprising a cascode or half-bridge circuit, further semiconductor die 8 may be fixedly and electrically connected to another die terminal of semiconductor die 2, as detailed above. Substrate 3 and, if applicable, further semiconductor die 8 may be fixedly and electrically connected to die terminals of semiconductor die 2 using a conductive adhesive material, similarly to how semiconductor die 2 could be attached to die pad 7.

In Figure 4D, clips are provided, the clips comprising the leads. For example, a first clip is provided comprising clip lead 5a, and a second clip is provided comprising further clip lead 5b and another further clip lead 5c.

The first clip may have a first portion, corresponding to clip lead 5a, that is fixedly and electrically connected to substrate 3, and may have a supporting portion 11a that is supported by or fixedly connected to frame portion 9. The second ends of clip lead 5a may further be interconnected by dam-bars 12. The second clip may be provided in a similar manner. In particular, further clip lead 5b and another further clip lead 5c of the second clip may be fixedly and electrically connected to further semiconductor die 8, and its supporting portion 11b may be supported by or fixedly connected to frame portion 9. **In** an alternative embodiment, a separate clip (not shown) is provided for further clip lead 5b and further clip lead 5c, each separate clip comprising a separate supporting portion.

Here, it is noted that clip lead 5a and further clip leads 5b, 5c may be fixedly connected to substrate 3 and further semiconductor die 8, respectively, using a conductive adhesive material, such as a solder layer or a sinter layer. Furthermore, when manufacturing a plurality of packages simultaneously, the first clip and the second clip may be individually attached for each package in the row or array, or they may be provided in a clip frame matrix comprising a plurality of first clips and second clips. At a later stage, the first and second clips corresponding to different packages may be separated from one another.

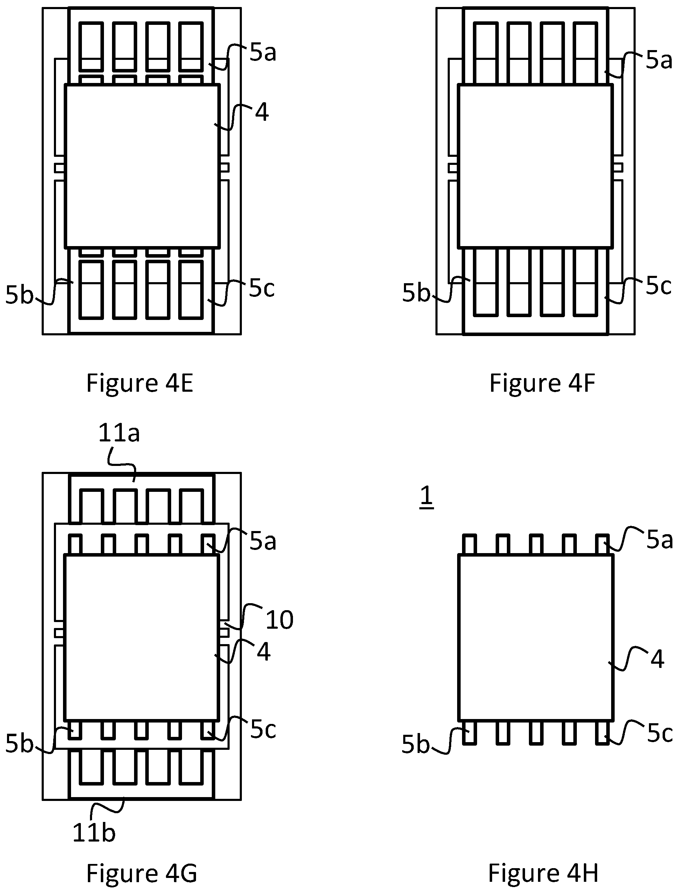

**In** Figure 4E, package material 4 is arranged to encapsulate semiconductor die 2, substrate 3, and , if applicable, further semiconductor die 8. As shown in Figure 4E, a portion of the first and second clip, in particular second ends of clip lead 5a and further clip leads 5b, 5c, are arranged externally to package material 4. As an example only, arranging package material 4 may comprise applying a molding compound and allowing said molding compound to solidify to thereby form a body of solidified molding compound.

**In** Figure 4F, dam-bars 12 between the second ends of clip lead 5a and further clip leads 5b, 5c are removed. For example, removing dam-bars 12 may comprise one or more of punching, drilling, cutting or sawing.

**In** Figure 4G, the second end(s) of clip lead 5a and further clip leads 5b, 5c are separated from supporting portions 11a, 11b of the first and second clip, respectively. For example, the separating may comprise one or more of punching, drilling, cutting or sawing.

Finally, in Figure 4H, semiconductor device package 1 is obtained by singulating the package from frame portion 9. For example, the step of singulating may comprise punching, drilling, cutting or sawing tie bars 10 to separate semiconductor device package 1 from the leadframe. At this stage, the second end(s) of clip lead 5a and further clip leads 5b, 5c may be formed in a particular shape, for example by means of bending. As an example only, the second end(s) of clip lead 5a and further clip leads 5b, 5c may be formed so as to be gullwing-shaped. However, it is noted that shaping the second ends may also be performed prior to singulation.

## Claims

1. A leadframe-based semiconductor device package (1), comprising:
a semiconductor die (2) having an electronic component integrated thereon and having a die terminal that is electrically connected to the electronic component;
a stress relief substrate (3) fixedly and electrically connected to the die terminal; and
a clip lead (5a),
wherein the substrate (3) is configured to provide an electrical short between the clip lead (5a) and the die terminal,
**characterized in that** the stress relief substrate (3) is further configured to bridge a difference between a coefficient of thermal expansion of the clip lead (5a) and a coefficient of thermal expansion of a die substrate of the semiconductor die (2), and **in that** the stress relief substrate (3) has a coefficient of thermal expansion that is lower than that of the clip lead (5a).

2. The semiconductor device package (1) according to claim 1, wherein the stress relief substrate (3) is configured to distribute a mechanical force exerted by the clip lead (5a).

3. The semiconductor device package (1) according to claim 1 or 2, wherein the stress relief substrate (3) comprises a dielectric material having arranged therein a plurality of conductive vias (6), and wherein the clip lead (5a) is electrically connected to the die terminal through said plurality of conductive vias,
wherein the stress relief substrate (3) preferably comprises a printed circuit board, 'PCB', including said dielectric material and conductive vias (6), wherein the conductive vias (6) preferably comprise a conductive material, such as copper, gold, aluminium, tungsten, nickel or graphene.

4. The semiconductor device package (1) according to claim 1 or 2, wherein the stress relief substrate (3) comprises a crystalline or polycrystalline material, wherein the clip lead (5a) is electrically connected to the die terminal through said crystalline or polycrystalline material.

5. The semiconductor device package (1) according to any of the previous claims, wherein the clip lead (5a) comprises a first end that is fixedly and electrically connected to the stress relief substrate (3), wherein a contact surface area of the substrate (3) with respect to the die terminal is preferably greater than a contact surface area of the clip lead (5a) with respect to the stress relief substrate (3), and/or
wherein the semiconductor device package (1) further comprises a package material (4) that encapsulates the semiconductor die (2) and the stress relief substrate (3), wherein the clip lead (5a) comprises a second end that is arranged externally to the package material (4), wherein the package material (4) preferably comprises a molding compound.

6. The semiconductor device package (1) according to any of the previous claims, wherein the die terminal is arranged in a metal layer of a layer stack on top of the semiconductor die, the layer stack comprising a stack of one or more metal layers (M1, M2), one or more intermetallic dielectric layers (D1, D2) and one or more passivation layers (P); and/or
wherein the semiconductor die (2) is arranged on a die pad (7), wherein the die pad (7) is preferably conductive and electrically connected to the electronic component.

7. The semiconductor device package (1) according to any of the previous claims, further comprising:
a further semiconductor die (8) having a further electronic component integrated thereon and having a first further die terminal that is electrically connected to the further electronic component, wherein the first further die terminal is fixedly and electrically connected to another die terminal of the semiconductor die (2); and
a further clip lead (5b; 5c), a first end thereof being fixedly and electrically connected to a second further die terminal of the further semiconductor die (8) that is electrically connected to the further electronic component, and a second end thereof being arranged externally to the package material (4),
wherein, preferably, a thickness of the further semiconductor die (8) corresponds to a thickness of the stress relief substrate (3), and/or wherein the electronic component and/or, if applicable, the further electronic component comprises a bipolar junction transistor, BJT, or a field-effect transistor, 'FET', such as a high electron mobility transistor, 'HEMT' or a power metal oxide semiconductor FET, MOSFET, wherein the electronic component and the further electronic component together preferably form a cascode circuit or a half-bridge circuit.

8. The semiconductor device package (1) according to any of the previous claims, wherein at least one of the following applies:
the clip lead (5a) is fixedly and electrically connected to the stress relief substrate (3) using a conductive adhesive material;
the stress relief substrate (3) is fixedly and electrically connected to the die terminal using a conductive adhesive material;
in so far as depending on claim 6, the semiconductor die (2) is fixedly and electrically connected to the die pad (7) using a conductive adhesive material;
in so far as depending on claim 7, the further clip lead (5b; 5c) is fixedly and electrically connected to the second further die terminal using a conductive adhesive material;
in so far as depending on claim 7, the further semiconductor die (8) is fixedly and electrically connected to the another die terminal of the semiconductor die (2) using a conductive adhesive material,
wherein the conductive adhesive material preferably comprises a conductive epoxy, a solder layer, such as tin, or a sinter layer, such as sintered silver or copper.

9. The semiconductor device package (1) according to any of the previous claims, wherein the clip lead (5a) and, if applicable, the further clip lead (5b, 5c) are gullwing-shaped; and/or
wherein the semiconductor die (2) and/or, if applicable, the further semiconductor die (8) is based on one of Silicon, 'Si', Silicon Carbide, 'SiC', Gallium Nitride, 'GaN', or Gallium Arsenide, 'GaAs', technology.

10. A method for manufacturing a semiconductor device package (1), the method comprising the steps of:
a) providing a semiconductor die (2) having an electronic component integrated thereon and having a die terminal that is electrically connected to the electronic component;
b) providing a stress relief substrate (3) as defined in any of the claims 1-4, and fixedly and electrically connecting said stress relief substrate (3) to the die terminal; and
c) providing a clip lead (5a), wherein the stress relief substrate (3) provides an electrical short between the clip lead (5a) and the die terminal.

11. The method according to claim 10, wherein the clip lead (5a) comprises a first end that is fixedly and electrically connected to the stress relief substrate (3), wherein a contact surface area of the stress relief substrate (3) with respect to the die terminal is preferably greater than a contact surface area of the clip lead (5a) with respect to the stress relief substrate (3); and/or
wherein the method further comprises the step of:
d) providing a package material (4), preferably a molding compound, and arranging said package material (4) to encapsulate the semiconductor die (2) and the stress relief substrate (3), wherein a second end of the clip lead (5a) is arranged externally to the package material (4).

12. The method according to claim 10 or 11, wherein the semiconductor die (2) is fixedly arranged on a die pad (7), the die pad (7) being comprised in a leadframe, wherein the die pad (7) is preferably conductive and is preferably electrically connected to the electronic component,
wherein the leadframe further comprises a frame portion (9) to which the die pad (7) is fixedly connected, and wherein the method further comprises a step of e) singulating the semiconductor device package from the leadframe, preferably by performing at least one of punching, drilling, cutting or sawing,
wherein the leadframe preferably comprises a plurality of said frame portions (9) and die pads (7) for manufacturing a plurality of said semiconductor device packages (1).

13. The method according to any of the claims 10-12, wherein step b) further comprises providing a further semiconductor die (8) having a further electronic component integrated thereon and having a first further die terminal that is electrically connected to the further electronic component, wherein the first further die terminal is fixedly and electrically connected to another die terminal of the semiconductor die (2), and
wherein step c) further comprises providing a further clip lead (5b; 5c), and fixedly and electrically connecting a first end thereof to a second further die terminal of the further semiconductor die (8) that is electrically connected to the further electronic component, wherein a second end thereof is arranged externally to the package material (4),
wherein, preferably, a thickness of the further semiconductor die (8) corresponds to a thickness of the stress relief
substrate (3), and/or wherein the electronic component and/or, if applicable, the further electronic component comprises a bipolar junction transistor, 'BJT', or a field-effect transistor, 'FET', such as a high electron mobility transistor, 'HEMT' or a power metal oxide semiconductor FET, MOSFET, wherein the electronic component and the further electronic component together preferably form a cascode circuit or a half-bridge circuit.

14. The method according to any of the claims 10-13, wherein the clip lead (5a) and, if applicable, the further clip lead (5b; 5c) are comprised in one or more clips, wherein the one or more clips comprise a supporting portion (11a; 11b) that is arranged to be supported by or fixedly connected to the frame portion (9),
wherein the method further comprises, after step d), separating the clip lead (5a) and, if applicable, the further clip lead (5a; 5c) from the supporting portion (11a; 11b), preferably by performing at least one of punching, drilling, cutting or sawing.

15. The method according to any of the claims 10-14, wherein a conductive adhesive material, preferably comprising one of a conductive epoxy, a solder layer, such as tin, or a sinter layer, such as sintered silver or copper, is used for at least one of the following:
fixedly and electrically connecting the clip lead (5a) to the stress relief substrate (3);
fixedly and electrically connecting the stress relief substrate (3) to the die terminal;
in so far as depending on claim 12, fixedly and electrically connecting the semiconductor die (2) to the die pad (7);
in so far as depending on claim 13, fixedly and electrically connecting the further clip lead (5b; 5c) to the second further die terminal;
in so far as depending on claim 13, fixedly and electrically connecting the further semiconductor die (8) to the another die terminal of the semiconductor die (2).

## Patentansprüche

1. Leiterrahmenbasiertes Halbleiterelementgehäuse (1), umfassend:
einen Halbleiterchip (2) mit einem darauf integrierten elektronischen Bauteil und mit einem Chipanschluss, der mit dem elektronischen Bauteil elektrisch verbunden ist;
ein Spannungsentlastungssubstrat (3), das mit dem Chipanschluss fest und elektrisch verbunden ist; und
ein Clip-Anschlussbein (5a),
wobei das Substrat (3) dazu ausgebildet ist, einen elektrischen Kurzschluss zwischen dem Clip-Anschlussbein (5a) und dem Chipanschluss bereitzustellen,
**dadurch gekennzeichnet, dass** das Spannungsentlastungssubstrat (3) ferner dazu ausgebildet ist, eine Differenz zwischen einem Wärmedehnungskoeffizienten des Clip-Anschlussbeins (5a) und einem Wärmedehnungskoeffizienten eines Chipsubstrats des Halbleiterchips (2) zu überbrücken, und dadurch, dass das Spannungsentlastungssubstrat (3) einen Wärmedehnungskoeffizienten aufweist, der niedriger als derjenige des Clip-Anschlussbeins (5a) ist.

2. Halbleiterelementgehäuse (1) nach Anspruch 1, wobei das Spannungsentlastungssubstrat (3) dazu ausgebildet ist, eine von dem Clip-Anschlussbein (5a) ausgeübte mechanische Kraft zu verteilen.

3. Halbleiterelementgehäuse (1) nach Anspruch 1 oder 2, wobei das Spannungsentlastungssubstrat (3) ein Dielektrikum umfasst, in dem eine Vielzahl leitfähiger Durchkontaktierungen (6) angeordnet ist, und wobei das Clip-Anschlussbein (5a) durch die Vielzahl leitfähiger Durchkontaktierungen mit dem Chipanschluss elektrisch verbunden ist,
wobei das Spannungsentlastungssubstrat (3) vorzugsweise eine Leiterplatte, ,LP', die das Dielektrikum und die leitfähigen Durchkontaktierungen (6) enthält, umfasst, wobei die leitfähigen Durchkontaktierungen (6) vorzugsweise einen Leiterwerkstoff, wie etwa Kupfer, Gold, Aluminium, Wolfram, Nickel oder Graphen, umfassen.

4. Halbleiterelementgehäuse (1) nach Anspruch 1 oder 2, wobei das Spannungsentlastungssubstrat (3) einen kristallinen oder polykristallinen Werkstoff umfasst, wobei das Clip-Anschlussbein (5a) durch den kristallinen oder polykristallinen Werkstoff mit dem Chipanschluss elektrisch verbunden ist.

5. Halbleiterelementgehäuse (1) nach einem der vorherigen Ansprüche, wobei das Clip-Anschlussbein (5a) ein erstes Ende, das mit dem Spannungsentlastungssubstrat (3) fest und elektrisch verbunden ist, umfasst, wobei ein Kontaktflächeninhalt des Substrats (3) mit Bezug auf den Chipanschluss vorzugsweise größer als ein Kontaktflächeninhalt des Clip-Anschlussbeins (5a) mit Bezug auf das Spannungsentlastungssubstrat (3) ist, und/oder
wobei das Halbleiterelementgehäuse (1) ferner einen Gehäusewerkstoff (4), der den Halbleiterchip (2) und das Spannungsentlastungssubstrat (3) einkapselt, umfasst, wobei das Clip-Anschlussbein (5a) ein zweites Ende, das außerhalb des Gehäusewerkstoffs (4) angeordnet ist, umfasst, wobei der Gehäusewerkstoff (4) vorzugsweise eine Vergussmasse umfasst.

6. Halbleiterelementgehäuse (1) nach einem der vorherigen Ansprüche, wobei der Chipanschluss in einer Metallschicht eines Schichtstapels auf dem Halbleiterchip angeordnet ist, wobei der Schichtstapel einen Stapel aus einer oder mehreren Metallschichten (M1, M2), einer oder mehreren dielektrischen Zwischenmetallschichten (D1, D2) und einer oder mehreren Passivierungsschichten (P) umfasst; und/oder
wobei der Halbleiterchip (2) auf einer Chipbondinsel (7) angeordnet ist, wobei die Chipbondinsel (7) vorzugsweise leitfähig und mit dem elektronischen Bauteil elektrisch verbunden ist.

7. Halbleiterelementgehäuse (1) nach einem der vorherigen Ansprüche, ferner umfassend:
einen weiteren Halbleiterchip (8) mit einem weiteren darauf integrierten elektronischen Bauteil und mit einem ersten weiteren Chipanschluss, der mit dem weiteren elektronischen Bauteil elektrisch verbunden ist, wobei der erste weitere Chipanschluss mit einem anderen Chipanschluss des Halbleiterchips (2) fest und elektrisch verbunden ist; und
ein weiteres Clip-Anschlussbein (5b; 5c), wobei ein erstes Ende davon mit einem zweiten weiteren Chipanschluss des weiteren Halbleiterchips (8), der mit dem weiteren elektronischen Bauteil elektrisch verbunden ist, fest und elektrisch verbunden ist und ein zweites Ende davon außerhalb des Gehäusewerkstoffs (4) angeordnet ist,
wobei vorzugsweise eine Dicke des weiteren Halbleiterchips (8) einer Dicke des Spannungsentlastungssubstrats (3) entspricht und/oder wobei das elektronische Bauteil und/oder gegebenenfalls das weitere elektronische Bauteil einen Bipolartransistor, BJT, oder einen Feldeffekttransistor, ,FET', wie etwa einen High-Electron-Mobility-Transistor, ,HEMT', oder einen Leistungs-Metalloxid-Halbleiter-FET, Leistungs-MOSFET, umfassen/umfasst, wobei das elektronische Bauteil und das weitere elektronische Bauteil zusammen vorzugsweise eine Kaskodenschaltung oder eine Halbbrückenschaltung bilden.

8. Halbleiterelementgehäuse (1) nach einem der vorherigen Ansprüche, wobei mindestens eines von Folgendem zutrifft:
das Clip-Anschlussbein (5a) ist unter Verwendung eines leitfähigen Klebstoffs mit dem Spannungsentlastungssubstrat (3) fest und elektrisch verbunden;
das Spannungsentlastungssubstrat (3) ist unter Verwendung eines leitfähigen Klebstoffs mit dem Chipanschluss fest und elektrisch verbunden;
insofern abhängig von Anspruch 6, ist der Halbleiterchip (2) unter Verwendung eines leitfähigen Klebstoffs mit der Chipbondinsel (7) fest und elektrisch verbunden;
insofern abhängig von Anspruch 7, ist das weitere Clip-Anschlussbein (5b; 5c) unter Verwendung eines leitfähigen Klebstoffs mit dem zweiten weiteren Chipanschluss fest und elektrisch verbunden;
insofern abhängig von Anspruch 7, ist der weitere Halbleiterchip (8) unter Verwendung eines leitfähigen Klebstoffs mit dem anderen Chipanschluss des Halbleiterchips (2) fest und elektrisch verbunden,
wobei der leitfähige Klebstoff vorzugsweise ein leitfähiges Epoxid, eine Lötschicht, wie etwa Zinn, oder eine Sinterschicht, wie etwa gesintertes Silber oder Kupfer, umfasst.

9. Halbleiterelementgehäuse (1) nach einem der vorherigen Ansprüche, wobei das Clip-Anschlussbein (5a) und gegebenenfalls das weitere Clip-Anschlussbein (5b, 5c) knickflügelförmig sind; und/oder
wobei der Halbleiterchip (2) und/oder gegebenenfalls der weitere Halbleiterchip (8) auf einer von der Silicium- oder ,Si'-Technologie, der Siliciumcarbid- oder ,SiC'-Technologie, der Galliumnitrid- oder ,GaN'-Technologie oder der Galliumarsenid- oder 'GaAs'-Technologie basieren/basiert.

10. Verfahren zum Herstellen eines Halbleiterelementgehäuses (1), wobei das Verfahren folgende Schritte umfasst:
a) Bereitstellen eines Halbleiterchips (2) mit einem darauf integrierten elektronischen Bauteil und mit einem Chipanschluss, der mit dem elektronischen Bauteil elektrisch verbunden ist;
b) Bereitstellen eines Spannungsentlastungssubstrats (3) nach einem der Ansprüche 1-4 und festes und elektrisches Verbinden des Spannungsentlastungssubstrats (3) mit dem Chipanschluss; und
c) Bereitstellen eines Clip-Anschlussbeins (5a), wobei das Spannungsentlastungssubstrat (3) einen elektrischen Kurzschluss zwischen dem Clip-Anschlussbein (5a) und dem Chipanschluss bereitstellt.

11. Verfahren nach Anspruch 10, wobei das Clip-Anschlussbein (5a) ein erstes Ende, das mit dem Spannungsentlastungssubstrat (3) fest und elektrisch verbunden ist, umfasst, wobei ein Kontaktflächeninhalt des Spannungsentlastungssubstrats (3) mit Bezug auf den Chipanschluss vorzugsweise größer als ein Kontaktflächeninhalt des Clip-Anschlussbeins (5a) mit Bezug auf das Spannungsentlastungssubstrat (3) ist; und/oder
wobei das Verfahren ferner folgenden Schritt umfasst:
d) Bereitstellen eines Gehäusewerkstoffs (4), vorzugsweise einer Vergussmasse, und Anordnen des Gehäusewerkstoffs (4), um den Halbleiterchip (2) und das Spannungsentlastungssubstrat (3) einzukapseln, wobei ein zweites Ende des Clip-Anschlussbeins (5a) außerhalb des Gehäusewerkstoffs (4) angeordnet wird.

12. Verfahren nach Anspruch 10 oder 11, wobei der Halbleiterchip (2) auf einer Chipbondinsel (7) fest angeordnet wird, wobei die Chipbondinsel (7) in einem Leiterrahmen umfasst ist, wobei die Chipbondinsel (7) vorzugsweise leitfähig ist und vorzugsweise mit dem elektronischen Bauteil elektrisch verbunden ist,
wobei der Leiterrahmen ferner einen Rahmenabschnitt (9), mit dem die Chipbondinsel (7) fest verbunden ist, umfasst und wobei das Verfahren ferner einen Schritt des e) Heraustrennens des Halbleiterelementgehäuses aus dem Leiterrahmen, vorzugsweise durch das Durchführen von mindestens einem von Stanzen, Bohren, Schneiden oder Sägen, umfasst,
wobei der Leiterrahmen vorzugsweise eine Vielzahl der Rahmenabschnitte (9) und Chipbondinseln (7) zum Herstellen einer Vielzahl der Halbleiterelementgehäuse (1) umfasst.

13. Verfahren nach einem der Ansprüche 10-12, wobei Schritt b) ferner das Bereitstellen eines weiteren Halbleiterchips (8) mit einem weiteren darauf integrierten elektronischen Bauteil und mit einem ersten weiteren Chipanschluss, der mit dem weiteren elektronischen Bauteil elektrisch verbunden ist, umfasst, wobei der erste weitere Chipanschluss mit einem anderen Chipanschluss des Halbleiterchips (2) fest und elektrisch verbunden ist, und
wobei Schritt c) ferner das Bereitstellen eines weiteren Clip-Anschlussbeins (5b; 5c) und das feste und elektrische Verbinden eines ersten Endes davon mit einem zweiten weiteren Chipanschluss des weiteren Halbleiterchips (8), der mit dem weiteren elektronischen Bauteil elektrisch verbunden ist, umfasst, wobei ein zweites Ende davon außerhalb des Gehäusewerkstoffs (4) angeordnet ist,
wobei vorzugsweise eine Dicke des weiteren Halbleiterchips (8) einer Dicke des Spannungsentlastungssubstrats (3) entspricht und/oder wobei das elektronische Bauteil und/oder gegebenenfalls das weitere elektronische Bauteil einen Bipolartransistor, 'BJT', oder einen Feldeffekttransistor, ,FET', wie etwa einen High-Electron-Mobility-Transistor, 'HEMT', oder einen Leistungs-Metalloxid-Halbleiter-FET, Leistungs-MOSFET, umfassen/umfasst, wobei das elektronische Bauteil und das weitere elektronische Bauteil zusammen vorzugsweise eine Kaskodenschaltung oder eine Halbbrückenschaltung bilden.

14. Verfahren nach einem der Ansprüche 10-13, wobei das Clip-Anschlussbein (5a) und gegebenenfalls das weitere Clip-Anschlussbein (5b; 5c) in einem oder mehreren Clips umfasst sind, wobei der eine oder die mehreren Clips einen Stützabschnitt (11a; 11b) umfassen, der so angeordnet ist, dass er von dem Rahmenabschnitt (9) gestützt oder fest mit diesem verbunden wird,
wobei das Verfahren ferner Folgendes umfasst: nach Schritt d) Trennen des Clip-Anschlussbeins (5a) und gegebenenfalls des weiteren Clip-Anschlussbeins (5a; 5c) von dem Stützabschnitt (11a; 11b), vorzugsweise durch das Durchführen von mindestens einem von Stanzen, Bohren, Schneiden oder Sägen.

15. Verfahren nach einem der Ansprüche 10-14, wobei ein leitfähiger Klebstoff, der vorzugsweise eines von einem leitfähigen Epoxid, einer Lötschicht, wie etwa Zinn, oder einer Sinterschicht, wie etwa gesintertem Silber oder Kupfer, umfasst, für mindestens eines von Folgendem genutzt wird:
festes und elektrisches Verbinden des Clip-Anschlussbeins (5a) mit dem Spannungsentlastungssubstrat (3);
festes und elektrisches Verbinden des Spannungsentlastungssubstrats (3) mit dem Chipanschluss;
insofern abhängig von Anspruch 12, festes und elektrisches Verbinden des Halbleiterchips (2) mit der Chipbondinsel (7);
insofern abhängig von Anspruch 13, festes und elektrisches Verbinden des weiteren Clip-Anschlussbeins (5b; 5c) mit dem zweiten weiteren Chipanschluss;
insofern abhängig von Anspruch 13, festes und elektrisches Verbinden des weiteren Halbleiterchips (8) mit dem anderen Chipanschluss des Halbleiterchips (2).

## Revendications

1. Boîtier de dispositif à semi-conducteur à base de grille de connexion (1), comprenant :
une puce semi-conductrice (2) ayant un composant électronique intégré dessus et ayant une borne de puce qui est électriquement connectée au composant électronique ;
un substrat de détensionnement (3) connecté électriquement et à demeure à la borne de puce ; et
un conducteur de fixation (5a),
dans lequel le substrat (3) est conçu pour fournir un court-circuit électrique entre le conducteur de fixation (5a) et la borne de puce,
**caractérisé en ce que** le substrat de détensionnement (3) est en outre conçu pour couvrir une différence entre un coefficient de dilatation thermique du conducteur de fixation (5a) et un coefficient de dilatation thermique d'un substrat de puce de la puce semi-conductrice (2), et **en ce que** le substrat de détensionnement (3) a un coefficient de dilatation thermique qui est inférieur à celui du conducteur de fixation (5a).

2. Boîtier de dispositif à semi-conducteur (1) selon la revendication 1, dans lequel le substrat de détensionnement (3) est conçu pour répartir un effort mécanique exercé par le conducteur de fixation (5a).

3. Boîtier de dispositif à semi-conducteur (1) selon la revendication 1 ou 2, dans lequel le substrat de détensionnement (3) comprend un matériau diélectrique ayant agencés en son sein une pluralité de trous d'interconnexion conducteurs (6), et dans lequel le conducteur de fixation (5a) est électriquement connecté à la borne de puce via ladite pluralité de trous d'interconnexion conducteurs,
dans lequel le substrat de détensionnement (3) comprend de préférence une carte de circuit imprimé, « PCB », incluant ledit matériau diélectrique et lesdits trous d'interconnexion conducteurs (6), les trous d'interconnexion conducteurs (6) comprenant de préférence un matériau conducteur, tel que du cuivre, de l'or, de l'aluminium, du tungstène, du nickel ou du graphène.

4. Boîtier de dispositif à semi-conducteur (1) selon la revendication 1 ou 2, dans lequel le substrat de détensionnement (3) comprend un matériau cristallin ou polycristallin, dans lequel le conducteur de fixation (5a) est électriquement connecté à la borne de puce via ledit matériau cristallin ou polycristallin.

5. Boîtier de dispositif à semi-conducteur (1) selon l'une quelconque des revendications précédentes, dans lequel le conducteur de fixation (5a) comprend une première extrémité qui est connectée électriquement et à demeure au substrat de détensionnement (3), une superficie de contact du substrat (3) avec la borne de puce étant de préférence supérieure à une superficie de contact du conducteur de fixation (5a) avec le substrat de détensionnement (3),
et/ou
dans lequel le boîtier de dispositif à semi-conducteur (1) comprend en outre un matériau de boîtier (4) qui encapsule la puce semi-conductrice (2) et le substrat de détensionnement (3), le conducteur de fixation (5a) comprenant une deuxième extrémité qui est agencée à l'extérieur du matériau de boîtier (4), le matériau de boîtier (4) comprenant de préférence un composé de moulage.

6. Boîtier de dispositif à semi-conducteur (1) selon l'une quelconque des revendications précédentes, dans lequel la borne de puce est agencée dans une couche métallique d'une pile de couches sur la puce semi-conductrice, la pile de couches comprenant une pile d'une ou plusieurs couches métalliques (M1, M2), une ou plusieurs couches diélectriques intermétalliques (D1, D2) et une ou plusieurs couches de passivation (P) ; et/ou
dans lequel la puce semi-conductrice (2) est agencée sur une pastille de puce (7), la pastille de puce (7) étant de préférence conductrice et électriquement connectée au composant électronique.

7. Boîtier de dispositif à semi-conducteur (1) selon l'une quelconque des revendications précédentes, comprenant en outre :
une autre puce semi-conductrice (8) ayant un autre composant électronique intégré dessus et ayant une première autre borne de puce qui est électriquement connectée à l'autre composant électronique, la première autre borne de puce étant connectée électriquement et à demeure à une autre borne de puce de la puce semi-conductrice (2) ; et
un autre conducteur de fixation (5b ; 5c), dont une première extrémité est connectée électriquement et à demeure à une deuxième autre borne de puce de l'autre puce semi-conductrice (8) qui est électriquement connectée à l'autre composant électronique, et dont une deuxième extrémité est agencée à l'extérieur du matériau de boîtier (4),
dans lequel, de préférence, une épaisseur de l'autre puce semi-conductrice (8) correspond à une épaisseur du substrat de détensionnement (3), et/ou dans lequel le composant électronique et/ou, le cas échéant, l'autre composant électronique comprend un transistor à jonction bipolaire, BJT, ou un transistor à effet de champ, « FET », tel qu'un transistor à haute mobilité électronique, « HEMT » ou un FET à semi-conducteur à oxyde métallique de puissance, MOSFET, le composant électronique et l'autre composant électronique ensemble formant de préférence un circuit cascode ou un circuit demi-pont.

8. Boîtier de dispositif à semi-conducteur (1) selon l'une quelconque des revendications précédentes, dans lequel au moins l'une des conditions suivantes s'applique :
le conducteur de fixation (5a) est connecté électriquement et à demeure au substrat de détensionnement (3) à l'aide d'un matériau adhésif conducteur ;
le substrat de détensionnement (3) est connecté électriquement et à demeure à la borne de puce à l'aide d'un matériau adhésif conducteur ;
dans la mesure où on dépend de la revendication 6, la puce semi-conductrice (2) est connectée électriquement et à demeure à la pastille de puce (7) à l'aide d'un matériau adhésif conducteur ;
dans la mesure où on dépend de la revendication 7, l'autre conducteur de fixation (5b ; 5c) est connecté électriquement et à demeure à la deuxième autre borne de puce à l'aide d'un matériau adhésif conducteur ;
dans la mesure où on dépend de la revendication 7, l'autre puce semi-conductrice (8) est connectée électriquement et à demeure à l'autre borne de puce de la puce semi-conductrice (2) à l'aide d'un matériau adhésif conducteur,
le matériau adhésif conducteur comprenant de préférence un matériau conducteur époxy, une couche de brasure, telle que l'étain, ou une couche frittée, telle que d'argent ou de cuivre fritté.

9. Boîtier de dispositif à semi-conducteur (1) selon l'une quelconque des revendications précédentes, dans lequel le conducteur de fixation (5a) et, le cas échéant, l'autre conducteur de fixation (5b, 5c) sont mis en forme d'aile de mouette ; et/ou
dans lequel la puce semi-conductrice (2) et/ou, le cas échéant, l'autre puce semi-conductrice (8) est basée sur l'une d'une technologie au silicium, « Si », au carbure de silicium, « SiC », au nitrure de gallium, « GaN », ou à l'arséniure de gallium, « GaAs ».

10. Procédé de fabrication d'un boîtier de dispositif semi-conducteur (1), le procédé comprenant les étapes consistant à :
a) fournir une puce semi-conductrice (2) ayant un composant électronique intégré dessus et ayant une borne de puce qui est électriquement connectée au composant électronique ;
b) fournir un substrat de détensionnement (3) tel que défini dans l'une quelconque des revendications 1 à 4, et connecter électriquement et à demeure ledit substrat de détensionnement (3) à la borne de puce ; et
c) fournir un conducteur de fixation (5a), le substrat de détensionnement (3) fournissant un court-circuit électrique entre le conducteur de fixation (5a) et la borne de puce.

11. Procédé selon la revendication 10, dans lequel le conducteur de fixation (5a) comprend une première extrémité qui est connectée électriquement et à demeure au substrat de détensionnement (3), une superficie de contact du substrat de détensionnement (3) avec la borne de puce étant de préférence supérieure à une superficie de contact du conducteur de fixation (5a) avec le substrat de détensionnement (3) ; et/ou
dans lequel le procédé comprend en outre l'étape consistant à :
d) fournir un matériau de boîtier (4), de préférence un composé de moulage, et agencer ledit matériau de boîtier (4) pour encapsuler la puce semi-conductrice (2) et le substrat de détensionnement (3), une deuxième extrémité du conducteur de fixation (5a) étant agencée à l'extérieur du matériau de boîtier (4).

12. Procédé selon la revendication 10 ou 11, dans lequel la puce semi-conductrice (2) est agencée à demeure sur une pastille de puce (7), la pastille de puce (7) étant comprise dans une grille de connexion, la pastille de puce (7) étant de préférence conductrice et électriquement connectée au composant électronique,
la grille de connexion comprenant en outre une partie cadre (9) à laquelle la pastille de puce (7) est connectée à demeure, et le procédé comprenant en outre les étapes consistant à e) effectuer une singulation du boîtier de dispositif à semi-conducteur depuis la grille de connexion, de préférence en réalisant au moins l'un d'une perforation, d'un percement, d'une découpe ou d'un sciage,
la grille de connexion comprenant de préférence une pluralité desdites parties cadre (9) et de pastilles de puce (7) pour la fabrication d'une pluralité desdits boîtiers de dispositifs à semi-conducteur (1).

13. Procédé selon l'une quelconque des revendications 10 à 12, dans lequel l'étape b) comprend en outre la fourniture d'une autre puce semi-conductrice (8) ayant un autre composant électronique intégré dessus et ayant une première autre borne de puce qui est électriquement connectée à l'autre composant électronique, la première autre borne de puce étant connectée électriquement et à demeure à une autre borne de puce de la puce semi-conductrice (2), et
dans lequel l'étape c) comprend en outre la fourniture d'un autre conducteur de fixation (5b ; 5c), et la connexion électrique et à demeure d'une première extrémité de celui-ci à une deuxième autre borne de puce de l'autre puce semi-conductrice (8) qui est électriquement connectée à l'autre composant électronique, une deuxième extrémité de celui-ci étant agencée à l'extérieur du matériau de boîtier (4),
dans lequel, de préférence, une épaisseur de l'autre puce semi-conductrice (8) correspond à une épaisseur du substrat de détensionnement (3), et/ou dans lequel le composant électronique et/ou, le cas échéant, l'autre composant électronique comprend un transistor à jonction bipolaire, BJT, ou un transistor à effet de champ, « FET », tel qu'un transistor à haute mobilité électronique, « HEMT » ou un FET à semi-conducteur à oxyde métallique de puissance, MOSFET, le composant électronique et l'autre composant électronique ensemble formant de préférence un circuit cascode ou un circuit demi-pont.

14. Procédé selon l'une quelconque des revendications 10 à 13, dans lequel le conducteur de fixation (5a) et, le cas échéant, l'autre conducteur de fixation (5b ; 5c) sont compris dans une ou plusieurs fixations, les une ou plusieurs fixations comprenant une partie de support (11a ; 11b) qui est conçue pour être supportée par ou connectée à demeure à la partie cadre (9),
le procédé comprenant en outre les étapes consistant à, après l'étape d), séparer le conducteur de fixation (5a) et, le cas échéant, l'autre conducteur de fixation (5a ; 5c) de la partie de support (11a ; 11b), de préférence en réalisant au moins l'un d'une perforation, d'un percement, d'une découpe ou d'un sciage.

15. Procédé selon l'une quelconque des revendications 10 à 14, dans lequel un matériau adhésif conducteur, de préférence comprenant l'un d'un époxy conducteur, une couche de brasure, telle que de l'étain, ou une couche frittée, telle qu'une d'argent ou de cuivre fritté, est utilisé pour au moins l'une des applications suivantes :
connecter électriquement et à demeure le conducteur de fixation (5a) au substrat de détensionnement (3) ;
connecter électriquement et à demeure le substrat de détensionnement (3) à la borne de puce ;
dans la mesure où on dépend de la revendication 12, connecter électriquement et à demeure la puce semi-conductrice (2) à la pastille de puce (7) ;
dans la mesure où on dépend de la revendication 13, connecter électriquement et à demeure l'autre conducteur de fixation (5b ; 5c) à la deuxième autre borne de puce ;
dans la mesure où on dépend de la revendication 13, connecter électriquement et à demeure l'autre puce semi-conductrice (8) à l'autre borne de puce de la puce semi-conductrice (2).
